# EUROPEAN PATENT APPLICATION

(11) **EP 4 113 719 A1**
(43) Date of publication of application: **04.01.2023**
(21) Application number: 21892080.9
(22) Date of filing: 29.07.2021
(51) Int. Cl.: H01M 50/209, H01M 50/572, H01M 10/42, B23K 26/21, H05K 1/03, H05K 1/09, B23K 101/38

(54) **BATTERY PACK HAVING CIRCUIT BOARD AND ELECTRODE LEAD BONDED DIRECTLY TO EACH OTHER BY LASER WELDING METHOD**

(30) Priority: 10.11.2020 KR 20200149131
(71) Applicant: LG Energy Solution, Ltd., Seoul 07335 (KR)
(72) Inventor: KIM, Sang Jin, Daejeon 34122 (KR); LEE, Jin Hyun, Daejeon 34122 (KR); JANG, Jae Young, Daejeon 34122 (KR); JUNG, Dae Ho, Daejeon 34122 (KR)
(74) Representative: Plasseraud IP
(86) International application number: PCT/KR2021/009931
(87) International publication number: WO 2022/102910

(57) **Abstract**

The present invention relates to a battery pack including a battery cell including a pair of electrode leads constituted by a positive electrode lead and a negative electrode lead, a pack housing configured to receive the battery cell therein, and a protection circuit module (PCM) having a protection circuit formed on a printed circuit board (PCB), the protection circuit being configured to control operation of the battery cell, wherein the electrode leads are directly bonded to a surface copper foil layer of the PCB by laser welding.

## Description

### [Technical Field]

This application claims the benefit of priority to Korean Patent Application No. 2020-0149131 filed on November 10, 2020, the disclosure of which is incorporated herein by reference in its entirety.

The present invention relates to a battery pack having a circuit board of a protection circuit module and electrode leads directly bonded to each other by continuous wave type laser welding.

### [Background Art]

With technological development of mobile devices, such as smartphones, laptop computers, and digital cameras, and an increase in demand therefor, research on secondary batteries, which are capable of being charged and discharged, has been actively conducted. In addition, secondary batteries, which are energy sources substituting for fossil fuels causing air pollution, have been applied to an electric vehicle (EV), a hybrid electric vehicle (HEV), a plug-in hybrid electric vehicle (P-HEV), and an energy storage system (ESS).

There are a lithium secondary battery, a nickelcadmium battery, a nickel-hydride battery, and a nickelzinc battery as secondary batteries that are widely used at present. In particular, research and development on the lithium secondary battery, which has advantages of high operating voltage and high energy density per unit weight, have been actively conducted.

However, the lithium secondary battery has risks of heat emission or explosion due to overcharging, overcurrent, or external impact.

In general, therefore, the lithium secondary battery is manufactured in the form of a battery pack including a housing configured to receive the secondary battery therein in order to protect the secondary battery from external impact and a protection circuit module (PCM) configured to control overcharging or overcurrent.

In order to electrically connect the protection circuit module and the secondary battery to each other, it is necessary to bond electrode leads to the protection circuit module.

Bonding may be performed using various known welding methods. In recent years, however, laser welding, particularly pulse type laser welding using an Nd:YAG laser having an oscillation wavelength of about 0.5 to 1.1 µm, has been mainly used in the aspect of increase in productivity.

In the conventional laser welding, however, it is difficult to directly weld the electrode leads and a board of the protection circuit module to each other in the case in which the electrode leads are made of aluminum or an aluminum alloy, since there are problems, such as high-temperature cracks and low absorptivity of aluminum and reduction in electrical conductivity due to an intermetallic compound of aluminum and copper formed at a bonded portion between aluminum and a surface copper foil layer of board of the protection circuit module, which are dissimilar metals.

Conventionally, therefore, a welding method using metal pads made of nickel as connection members is applied to solve the above problems.

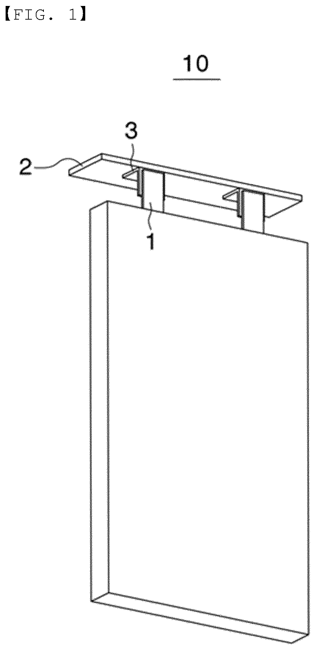

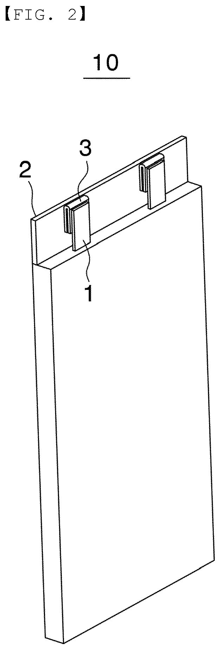

FIG. 1 is a perspective view showing a conventional battery pack having electrode leads and a protection circuit module welded to each other using metal pads, and FIG. 2 is a perspective view showing the conventional battery pack in the state in which the electrode leads and the protection circuit module are welded to each other and the metal pads are bent.

A method of bonding the electrode leads and the protection circuit module to each other in the conventional battery pack will be described with reference to FIGS. 1 and 2. First, metal pads 3 are bonded to a surface copper foil layer of a board of the protection circuit module 2, i.e. a printed circuit board (PCB), by soldering, electrode leads 1 are welded to the metal pads, and the metal pads 3 are bent, whereby bonding between the electrode leads 1 and the protection circuit module 2 is achieved.

In this method, however, the process is complicated and manufacturing cost is increased, since the metal pads are used.

### [Disclosure]

### [Technical Problem]

The present invention has been made in view of the above problems, and it is an object of the present invention to provide a battery pack having a circuit board of a protection circuit module and electrode leads directly bonded to each other using a continuous wave type laser welding method.

### [Technical Solution]

In order to accomplish the above object, a battery pack according to the present invention includes a battery cell including a pair of electrode leads including a positive electrode lead and a negative electrode lead, a pack housing configured to receive the battery cell therein, and a protection circuit module (PCM) having a protection circuit formed on a printed circuit board (PCB), the protection circuit being configured to control an operation of the battery cell, wherein the pair of electrode leads are directly bonded to a surface copper foil layer of the PCB by laser welding.

Also, in the battery pack according to the present invention, the battery cell may be a pouch-shaped battery cell.

Also, in the battery pack according to the present invention, the PCB may be a double-sided PCB having a structure in which a prepreg layer is located between two copper foil layers.

Also, in the battery pack according to the present invention, the PCB may be a multilayered PCB having a structure in which copper foil layers and prepreg layers are alternately stacked.

Also, in the battery pack according to the present invention, the laser welding may be a continuous wave type laser welding.

Also, in the battery pack according to the present invention, the laser welding may be the continuous wave type laser welding using a fiber laser.

Also, in the battery pack according to the present invention, the positive electrode lead may include one of aluminum, an aluminum alloy, copper, a copper alloy, nickel, and a nickel alloy.

Also, in the battery pack according to the present invention, the negative electrode lead may include one of copper, a copper alloy, nickel, and a nickel alloy.

Also, in the battery pack according to the present invention, the positive electrode lead may include aluminum or an aluminum alloy.

In addition, a device according to the present invention includes the battery pack.

In addition, the device according to the present invention may be one of a mobile phone, a portable computer, and a tablet PC.

### [Advantageous Effects]

A battery pack according to the present invention has an advantage in that electrode leads are directly welded to a copper foil layer of a PCB of a protection circuit module without using separate connection members, such as metal pads, whereby it is possible to simplify a battery pack manufacturing process.

In addition, the battery pack according to the present invention has an advantage in that the process is simplified and no separate connection members are used, whereby it is possible to reduce manufacturing cost.

### [Description of Drawings]

FIG. 1 is a perspective view showing a conventional battery pack having electrode leads and a protection circuit module welded to each other using metal pads.
FIG. 2 is a perspective view showing the conventional battery pack in the state in which the electrode leads and the protection circuit module are welded to each other and the metal pads are bent.
FIG. 3 is a perspective view showing a battery pack having electrode leads and a protection circuit module directly welded to each other according to an embodiment of the present invention.
FIG. 4 is a sectional view showing a portion at which the electrode lead and the protection circuit module are welded to each other according to an embodiment of the present invention.

### [Best Mode]

In the present application, it should be understood that the terms "comprises," "has," "includes," etc. specify the presence of stated features, numbers, steps, operations, elements, components, or combinations thereof, but do not preclude the presence or addition of one or more other features, numbers, steps, operations, elements, components, or combinations thereof.

In addition, the same reference numbers will be used throughout the drawings to refer to parts that perform similar functions or operations. In the case in which one part is said to be connected to another part in the specification, not only may the one part be directly connected to the other part, but also, the one part may be indirectly connected to the other part via a further part. In addition, that a certain element is included does not mean that other elements are excluded, but means that such elements may be further included unless mentioned otherwise.

Hereinafter, a battery pack according to the present invention will be described with reference to the accompanying drawings.

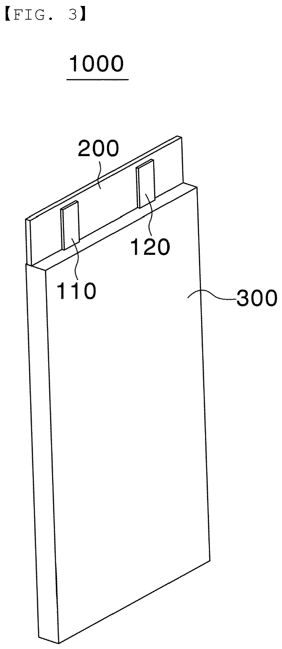

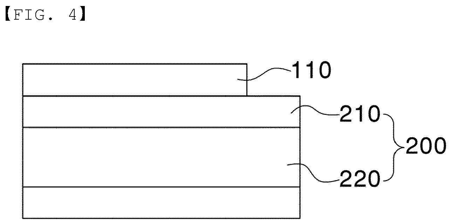

FIG. 3 is a perspective view showing a battery pack having electrode leads and a protection circuit module directly welded to each other according to an embodiment of the present invention, and FIG. 4 is a sectional view showing a portion at which the electrode lead and the protection circuit module are welded to each other according to an embodiment of the present invention.

When describing the battery pack 1000 according to the present invention with reference to FIGS. 3 and 4, the battery pack 1000 according to the present invention includes a battery cell, a protection circuit module, and a pack housing 300.

First, the battery cell includes an electrode assembly, a case configured to receive the electrode assembly therein, and a pair of electrode leads 110 and 120 constituted by a positive electrode lead and a negative electrode lead. In particular, it is preferable for the battery cell according to the present invention to be a pouch-shaped battery cell.

Here, the electrode assembly may be a jelly-roll type assembly, which is configured to have a structure in which a long sheet type positive electrode and a long sheet type negative electrode are wound in the state in which a separator is interposed therebetween, a stacked type assembly, which is configured to have a structure in which a rectangular positive electrode and a rectangular negative electrode are stacked in the state in which a separator is interposed therebetween, a stacked and folded type assembly, which is configured to have a structure in which unit cells are wound using a long separation film, or a laminated and stacked type assembly, which is configured to have a structure in which unit cells are stacked in the state in which a separator is interposed therebetween and are then attached to each other. However, the present invention is not limited thereto.

Also, it is obvious that an electrolyte may be replaced by a solid electrolyte or a gel type quasi-solid electrolyte obtained by adding an additive to a solid electrolyte, the gel type quasi-solid electrolyte having an intermediate phase between a liquid and a solid, in addition to a liquid electrolyte, which is commonly used.

The electrode assembly is received in the battery case, and the battery case generally has a laminate sheet structure including an inner layer, a metal layer, and an outer layer. The inner layer is disposed in direct contact with the electrode assembly, and therefore the inner layer must exhibit high insulation properties and high resistance to an electrolytic solution. In addition, the inner layer must exhibit high sealability in order to hermetically seal the battery case from the outside, i.e. a thermallybonded sealed portion between inner layers must exhibit excellent thermal bonding strength.

The inner layer may be made of a material selected from among a polyolefin-based resin, such as polypropylene, polyethylene, polyethylene acrylate, or polybutylene, a polyurethane resin, and a polyimide resin, which exhibit excellent chemical resistance and high sealability. However, the present invention is not limited thereto, and polypropylene, which exhibits excellent mechanical-physical properties, such as tensile strength, rigidity, surface hardness, and resistance to impact strength, and excellent chemical resistance, is the most preferably used.

The metal layer, which is disposed so as to abut the inner layer, corresponds to a barrier layer configured to prevent moisture or various kinds of gas from permeating into the battery from the outside. An aluminum thin film, which is light and easily shapeable, may be used as a preferred material for the metal layer.

The outer layer is provided on the other surface of the metal layer. The outer layer may be made of a heat-resistant polymer that exhibits excellent tensile strength, resistance to moisture permeation, and resistance to air transmission such that the outer layer exhibits high heat resistance and chemical resistance while protecting the electrode assembly. As an example, the outer layer may be made of nylon or polyethylene terephthalate. However, the present invention is not limited thereto.

Meanwhile, the pair of electrode leads 110 and 120 are constituted by a positive electrode lead and a negative electrode lead. The electrode leads may be exposed outwards from the battery case in the state in which a positive electrode tab and a negative electrode tab of the cell assembly are electrically connected to the electrode leads, or may be directly connected to the cell assembly in the state in which the tabs are omitted.

Each of the electrode leads 110 and 120 is generally made of a metal material that exhibits excellent electrical conductivity. As an example, it is preferable for the positive electrode lead to be made of aluminum, copper, nickel, stainless steel, or an alloy thereof, and it is preferable for the negative electrode lead to be made of copper, nickel, stainless steel, or an alloy thereof. However, the present invention is not limited thereto.

The protection circuit module is configured to have a structure in which various devices configured to protect the battery cell from abnormality, such as overcharging or overcurrent, are mounted on a printed circuit board (PCB) 200 to form a protection circuit

Here, the PCB has various forms depending on stacked structures thereof. In brief, the PCB may be classified as a single-sided PCB having a structure in which a single layer of copper foil and a single layer of prepreg are stacked, a double-sided PCB having a structure in which a prepreg layer 220 is located between copper foil layers 210 on opposite surfaces thereof, or a multilayered PCB having a structure in which copper foil layers and prepreg layers are alternately stacked.

That is, the PCB 200 has a structure in which at least one copper foil layer 210 is formed at the surface thereof. In order to electrically connect the protection circuit module and the electrode leads 110 and 120 to each other, it is necessary to perform a process of bonding the copper foil layer 210 and the electrode leads 110 and 120 to each other.

Meanwhile, although the case in which the PCB 200 is a double-sided PCB 200 is defined and shown in FIG. 4, the present invention is not limited thereto, and various kinds of PCBs may be used.

In the battery pack 1000 according to the present invention, the copper foil layer 210 of the PCB 200 and the electrode leads 110 and 120 may be directly welded to each other without connection members, such as metal pads, using a laser welding method, particularly a continuous wave type laser welding method.

Here, the continuous wave type laser welding method is a welding method using a laser configured to continuously generate laser light, unlike a pulse wave type laser welding method.

Representative examples of the continuous wave type laser include a CO₂ laser and a fiber laser using optical fiber. The CO₂ laser oscillates infrared light having a wavelength of 10.6 µm and exhibits high efficiency, and therefore it is possible to easily obtain high output.

The continuous wave type laser has an advantage in that the beam size thereof is smaller and energy density thereof is higher than an Nd:YAG laser mainly used for the pulse wave type laser welding method, whereby it is possible to weld dissimilar metals having low absorptivity, such as Al and Cu. Consequently, it is possible to directly weld the electrode leads and the copper foil layer 210 of the PCB 200 to each other without separate connection members, such as metal pads.

In particular, the fiber laser has an advantage in that light having a specific wavelength is amplified using optical fiber, whereby it is possible to easily obtain a high-output laser of several kW, and power consumption thereof is lower than power consumption of existing lasers.

Meanwhile, the pack housing 300, which is configured to receive the battery cell therein in order to protect the battery cell from external impact, may be formed so as to have various shapes and may be made of various materials depending on the use of the battery pack 1000.

Next, a method of manufacturing a battery pack according to the present invention will be described in brief. First, a pouch-shaped battery cell including a pair of electrode leads 110 and 120 is manufactured, and various parts configured to protect the battery cell are mounted on a PCB 200 to manufacture a protection circuit module through a separate process.

Subsequently, the electrode leads 110 and 120 and a copper foil layer 210 of the PCB 200 are directly bonded to each other by continuous wave type laser welding, the same is received in a pack housing 300, and packaging is performed, whereby a battery pack 1000 may be manufactured.

Alternatively, the battery cell may be received in the pack housing 300, and then the electrode leads 110 and 120 and the copper foil layer 210 of the PCB 200 may be welded to each other.

The battery pack 1000 manufactured as described above may be used as a power supply for various kinds of devices.

In particular, the battery pack 1000 according to the present invention may be used in a device, such as a mobile phone, a portable computer, or a tablet PC; however, the present invention is not limited thereto.

Although the specific details of the present invention have been described in detail, those skilled in the art will appreciate that the detailed description thereof discloses only preferred embodiments of the present invention and thus does not limit the scope of the present invention. Accordingly, those skilled in the art will appreciate that various changes and modifications are possible, without departing from the category and technical idea of the present invention, and it will be obvious that such changes and modifications fall within the scope of the appended claims.

### (Description of Reference Numerals)

- 1000:: Battery pack
- 110, 120:: Electrode leads
- 200:: PCB
- 210:: Copper foil layer
- 220:: Prepreg layer
- 300:: Pack housing

## Claims

1. A battery pack (1000) comprising:
a battery cell comprising a pair of electrode leads (110, 120) including a positive electrode lead and a negative electrode lead;
a pack housing (300) configured to receive the battery cell therein; and
a protection circuit module (PCM) having a protection circuit formed on a printed circuit board (PCB) (200), the protection circuit being configured to control an operation of the battery cell,
wherein the pair of electrode leads (110, 120) are directly bonded to a surface copper foil layer (210) of the PCB (200) by a laser welding.

2. The battery pack (1000) according to claim 1, wherein the battery cell is a pouch-shaped battery cell.

3. The battery pack (1000) according to claim 2, wherein the PCB (200) is a double-sided PCB (200) having a structure in which a prepreg layer (220) is located between two copper foil layers (210).

4. The battery pack (1000) according to claim 2, wherein the PCB (200) is a multilayered PCB (200) having a structure in which the copper foil layers (210) and prepreg layers (220) are alternately stacked.

5. The battery pack (1000) according to claim 1, wherein the laser welding is a continuous wave type laser welding.

6. The battery pack (1000) according to claim 5, wherein the laser welding is the continuous wave type laser welding using a fiber laser.

7. The battery pack (1000) according to claim 1, wherein the positive electrode lead includes one of aluminum, an aluminum alloy, copper, a copper alloy, nickel, and a nickel alloy.

8. The battery pack (1000) according to claim 1, wherein the negative electrode lead includes one of copper, a copper alloy, nickel, and a nickel alloy.

9. The battery pack (1000) according to claim 7, wherein the positive electrode lead includes aluminum or an aluminum alloy.

10. A device comprising the battery pack (1000) according to any one of claims 1 to 9.

11. The device according to claim 10, wherein the device is one of a mobile phone, a portable computer, and a tablet PC.
